(19)

Europäisches Patentamt
European Patent Office
Office européen des brevets

(11) **EP 4 567 692 A1**

(12) **EUROPEAN PATENT APPLICATION**

(43) Date of publication:
**11.06.2025 Bulletin 2025/24**

(21) Application number: **24210188.9**

(22) Date of filing: **31.10.2024**

(51) International Patent Classification (IPC):
**G06Q 10/0631** (2023.01)   **A23B 7/00** (2006.01)
**A23L 19/00** (2016.01)   **G06F 30/20** (2020.01)
**G06Q 10/08** (2024.01)   **G06Q 10/083** (2024.01)
**G06Q 10/087** (2023.01)   **G06Q 30/0201** (2023.01)
**G06Q 30/0202** (2023.01)

(52) Cooperative Patent Classification (CPC):
**G06Q 10/08; G06F 30/20; G06Q 10/06315;**
**G06Q 10/083; G06Q 10/087; G06Q 30/0201;**
**G06Q 30/0202;** A23B 7/00

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **05.12.2023  IN 202321082913**

(71) Applicant: **Tata Consultancy Services Limited**
**Maharashtra (IN)**

(72) Inventors:
• **YADAV, ABHISHEK**
  **411057 Pune, Maharashtra (IN)**

• **BARAT, SOUVIK**
  **411057 Pune, Maharashtra (IN)**
• **PARANJAPE, ADITYA AVINASH**
  **411057 Pune, Maharashtra (IN)**
• **DESHPANDE, PARIJAT DILIP**
  **411028 Pune, Maharashtra (IN)**
• **KULKARNI, VINAY**
  **411057 Pune, Maharashtra (IN)**
• **RAI, BEENA**
  **411057 Pune, Maharashtra (IN)**

(74) Representative: **Goddar, Heinz J.**
**Boehmert & Boehmert**
**Anwaltspartnerschaft mbB**
**Pettenkoferstrasse 22**
**80336 München (DE)**

(54) **SYSTEMS AND METHODS FOR EVALUATING SUSTAINABILTY OF A FOOD SUPPLY CHAIN NETWORK USING DIGITAL TWIN**

(57)     There is a challenge in creating a seamless food supply chain that aligns with unique characteristics of each food item while considering business values. The present disclosure address the challenges associated with the food supply chain by providing a system and method for evaluating sustainability of a food supply chain network using digital twin. The present discourse describes developing a set of modeling abstractions and a digital twin-based approach to explore ideal supply chains for food, aiming to reduce food wastage, ensure food quality and improve profit margins. In the present disclosure, unique characteristics of fruit supply chains are described which are further applied to food supply chains. Using the characteristics of climacteric fruits, unique requirements that contemporary perishable food supply chains need to consider are described. Furthermore, a digital twin-based approach specifically designed for climacteric fruits is provided to address modeling requirements and enable evidence-based and justification-backed holistic decision-making.

200

Providing, a virtual representation of a food supply chain network using a stock-and-flow based model, wherein the stock-and-flow based model represents a plurality of dynamics of the food supply chain network — 202

Obtaining, a plurality of data associated with each of a plurality of food items at one or more instances in the virtual representation of the food supply chain network using a food digital twin, wherein the plurality of data is inputted to the stock-and-flow based model — 204

Determining, a status of a plurality of attributes associated with each of the plurality of food items using the plurality of data, wherein the plurality of attributes are indicative of a perishability aspect of each food item from the plurality of food items — 206

Analyzing, the plurality of dynamics of the food supply chain network based on the status of the plurality of attributes associated with each of the plurality of food items using a set of modelling abstractions — 208

Determining in real time, efficacy of each of the set of modelling abstractions for analyzing the plurality of dynamics of the food supply chain network by simulating the stock-and-flow based model using a simulator — 210

Evaluating, sustainability of the food supply chain network based on the efficacy of each of the set of modelling abstractions — 212

**FIG. 2**

EP 4 567 692 A1

**Description**

CROSS-REFERENCE TO RELATED APPLICATIONS AND PRIORITY

The present application claims priority to Indian application no. 202321082913, filed on 05 December 2023.

TECHNICAL FIELD

The disclosure herein generally relates to the field of energy resources, and, more particularly, to systems and methods for evaluating sustainability of a food supply chain network using a digital twin.

BACKGROUND

With expansion of food supply chain network and especially fruit supply chain network, global market for fresh fruits and vegetables is experiencing significant growth primarily driven by increasing health consciousness and adoption of healthy dietary. Technological advancements, such as cost-effective temperature-controlled vehicles, modified atmosphere packaging, and edible coatings, to maintaining freshness and extending shelf life of fruits and vegetables have also contributed to such growth globally. While the global fruits and vegetable market presents substantial potential and business opportunities, supplying perishable food items across the world comes with distinct complexities and uncertainties compared to the traditional supply chain of non-perishable food items. Supporting a supply chain for perishable food items, such as climacteric fruits and vegetables, poses a complex multi-variate multi-dimensional optimization problem that requires food item-specific solutions. A comprehensive solution necessitates careful consideration of all the factors such as demand, consumption patterns, and dynamics of perishability at various stages of the supply chain. Furthermore, supporting sustainability objectives, such as United Nation-sustainable development goals (SDGs) UN-SDG 2 (i.e., zero Hunger) and SDG 12.3 (i.e., responsible consumption and production), has become imperative in recent times.

Traditional supply chains that focus solely on volume and cost optimization often fall short in meeting essential characteristics such as food quality, safety, and sustainability goals. Further, existing mathematical and enterprise model-based approaches that adopt a reductionist view and focus only on a part of the whole problem as optimization problems targeting one or limited key performance indicators (KPIs), are also inadequate for contemporary perishable food supply chains. In an existing approach, the optimization technique focuses on dynamic pricing to reduce perishable food waste at the retailer end. Another existing approach show how donations alter economics of a food market. All these approaches primarily lack a holistic view and often fail to provide a globally robust solution, if not an optimized one, taking into account dynamics of food perishability and other critical dynamics of an end-to-end food supply chain.

SUMMARY

Embodiments of the present disclosure present technological improvements as solutions to one or more of the above-mentioned technical problems recognized by the inventors in conventional systems. For example, in one embodiment, a processor implemented method is provided. The processor implemented method, comprising providing, via one or more hardware processors, a virtual representation of a food supply chain network using a stock-and-flow based model, wherein the stock-and-flow based model represents a plurality of dynamics of the food supply chain network; obtaining, via the one or more hardware processors, a plurality of data associated with each of a plurality of food items at one or more instances in the virtual representation of the food supply chain network using a food digital twin, wherein the plurality of data is inputted to the stock-and-flow based model, determining, via the one or more hardware processors, a status of a plurality of attributes associated with each of the plurality of food items using the plurality of data, wherein the plurality of attributes are indicative of a perishability aspect of each food item from the plurality of food items; analyzing, via the one or more hardware processors, the plurality of dynamics of the food supply chain network based on the status of the plurality of attributes associated with each of the plurality of food items using a set of modelling abstractions; determining in real time, via the one or more hardware processors, efficacy of each of the set of modelling abstractions for analyzing the plurality of dynamics of the food supply chain network by simulating the stock-and-flow based model using a simulator; and evaluating, via the one or more hardware processors, sustainability of the food supply chain network based on the efficacy of each of the set of modelling abstractions.

In another aspect, a system is provided. The system comprising a memory storing instructions; one or more communication interfaces; and one or more hardware processors coupled to the memory via the one or more communication interfaces, wherein the one or more hardware processors are configured by the instructions to: provide a virtual representation of a food supply chain network using a stock-and-flow based model, wherein the stock-and-flow based model represents a plurality of dynamics of the food supply chain network; obtain a plurality of data associated with each of a plurality of food items at one or more instances in the virtual representation of the food supply chain network using a food digital twin, wherein the plurality of data is inputted to the stock-and-flow based model, determine a status of a plurality of attributes associated with each of the plurality of food items using the plurality of data, wherein the plurality of attributes are indicative of a perishability aspect of each food item from the plurality of food items; analyze the plurality of dynamics of the food supply chain network based on the status of the plurality of attributes associated with each of the plurality of food items using a set of modelling abstractions; determine in real time, efficacy of each of the set of modelling abstractions for analyzing the plurality of dynamics of the food supply chain network by simulating the stock-and-flow based model using a simulator; and evaluate sustainability of the food supply chain network based on the efficacy of each of the set of modelling abstractions.

In yet another aspect, a non-transitory computer readable medium is provided. The non-transitory computer readable medium are configured by instructions for providing a virtual representation of a food supply chain network using a stock-and-flow based model, wherein the stock-and-flow based model represents a plurality of dynamics of the food supply chain network; obtaining a plurality of data associated with each of a plurality of food items at one or more instances in the virtual representation of the food supply chain network using a food digital twin, wherein the plurality of data is inputted to the stock-and-flow based model, determining a status of a plurality of attributes associated with each of the plurality of food items using the plurality of data, wherein the plurality of attributes are indicative of a perishability aspect of each food item from the plurality of food items; analyzing the plurality of dynamics of the food supply chain network based on the status of the plurality of attributes associated with each of the plurality of food items using a set of modelling abstractions; determining in real time efficacy of each of the set of modelling abstractions for analyzing the plurality of dynamics of the food supply chain network by simulating the stock-and-flow based model using a simulator; and evaluating sustainability of the food supply chain network based on the efficacy of each of the set of modelling abstractions.

In accordance with an embodiment of the present disclosure, the plurality of dynamics of the food supply chain network comprises dynamics of storage, dynamics of transportation, and dynamics of retailer.

In accordance with an embodiment of the present disclosure, the plurality of attributes comprises a ripening state and remaining shelf-life of each food item from the plurality of food items.

In accordance with an embodiment of the present disclosure, the dynamics of storage is analyzed based on a computed quantity of storage stock, an aggregated remaining shelf-life, a spoilage rate, a purchase rate, one or more variables representing storage-to-storage movements, one or more cost associated factors, and a donation parameter at one or more storage points.

In accordance with an embodiment of the present disclosure, the dynamics of transportation is analyzed based on type of vehicles, frequency of the vehicles, temperature control capability and the cost associated with the vehicles used for transportation.

In accordance with an embodiment of the present disclosure, the dynamics of retailer is analyzed based a grade distribution, grade flow and demand distribution of the plurality of food items at one or more retailer points.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 illustrates an exemplary system for evaluating sustainability of a food supply chain network using digital twin, according to some embodiments of the present disclosure.

FIG. 2 illustrates an exemplary flow diagram illustrating a method for evaluating sustainability of a food supply chain network using digital twin, in accordance with some embodiments of the present disclosure.

FIG. 3 illustrates high level dynamics and a plurality of factors having a prominent impact on Key performance indicators (KPIs) of the food supply chain network especially fruit supply chain network, in accordance with some embodiments of the present disclosure.

FIG. 4 illustrates a schematic view of the food supply chain network especially fruit supply chain network, in accordance with some embodiments of the present disclosure.

FIG. 5 illustrates an overview of the food digital twin and the food digital twin based design and exploration the food supply chain network especially fruit supply chain network, in accordance with some embodiments of the present disclosure.

FIGS. 6A through 6C provide schematic overview illustrating the plurality of dynamics of the food supply chain network especially fruit supply chain network, in accordance with some embodiments of the present disclosure.

FIGS. 7A through 7D depict an illustrative food supply chain network with one supply site, one warehouse, one distribution center, and one retailer respectively using a Vensim® model, in accordance with some embodiments of the present disclosure.

FIGS. 8A though 8D depict graphical representations illustrating experimental results for evaluating sustainability of a food supply chain network using digital twin, in accordance with some embodiments of the present disclosure.

## DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments. It is intended that the following detailed description be considered as exemplary only, with the true scope being indicated by the following embodiments described herein.

Climacteric fruits, such as apple, banana, papaya, and mango, are experiencing high demand due to their unique flavors, taste, and their nutritional and phytochemical properties. Despite their popularity and great nutritional value, the import, export, and transportation of these fruits worldwide to meet business demands are challenging due to their high perishability. Harvesting these fruits at an appropriate maturity stage and ensuring proper supply from a farming location to retailers are critical to offer ideally ripened fruits with desirable qualities, such as aroma, appearance, and structure, to consumers. Therefore, creating a seamless supply chain that aligns with the unique characteristics of each fruit while considering business values is essential.

The present disclosure address the challenges associated with the fruit supply chain by providing a system and method for evaluating sustainability of a food supply chain network using digital twin. Embodiments of the present disclosure provides developing a set of modeling abstractions and proposing a digital twins-based approach to explore ideal supply chains for fruits, aiming to reduce food wastage, ensure food quality and improve profit margins. In the present disclosure, unique characteristics of fruit supply chains are highlighted which are further applied to food supply chains. By focusing on the characteristics of climacteric fruits, unique requirements that contemporary perishable food supply chains need to consider are described. Furthermore, a digital twin-based approach specifically designed for climacteric fruits is provided to address modeling requirements and enable evidence-based and justification-backed holistic decision-making. More specifically, the present disclosure describes the following:

1. A set of modeling abstractions to capture interrelated dynamics of the food supply chain, including perishability dynamics, demand-supply dynamics, and price-demand dynamics.

2. A realization of the set of modeling abstractions using an existing modeling paradigm, which is a system dynamics model that demonstrates usefulness of existing modeling and simulation techniques for contemporary problems.

3. A concept of sustainable food supply chain digital twin that leverages an advanced sensing technology which is a food digital twin and effectively makes use of the realization of proposed abstractions. It demonstrates the utility of the proposed abstractions and the feasibility of a perishable food supply chain for comprehensive decision-making by effectively leveraging advanced food sensing technologies, such as enterprise models.

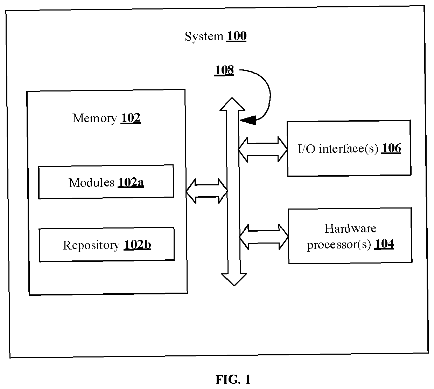

Referring now to the drawings, and more particularly to FIGS. 1 through 8D, where similar reference characters denote corresponding features consistently throughout the figures, there are shown preferred embodiments and these embodiments are described in the context of the following exemplary system and/or method.

FIG. 1 illustrates an exemplary system for evaluating sustainability of a food supply chain network using digital twin, according to some embodiments of the present disclosure. In an embodiment, the system 100 includes or is otherwise in communication with one or more hardware processors 104, communication interface device(s) or input/output (I/O) interface(s) 106, and one or more data storage devices or memory 102 operatively coupled to the one or more hardware processors 104. The one or more hardware processors 104, the memory 102, and the I/O interface(s) 106 may be coupled to a system bus 108 or a similar mechanism.

The I/O interface(s) 106 may include a variety of software and hardware interfaces, for example, a web interface, a graphical user interface, and the like. The I/O interface(s) 106 may include a variety of software and hardware interfaces, for example, interfaces for peripheral device(s), such as a keyboard, a mouse, an external memory, a plurality of sensor devices, a printer and the like. Further, the I/O interface(s) 106 may enable the system 100 to communicate with other devices, such as web servers and external databases.

The I/O interface(s) 106 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface(s) 106 may include one or more ports for connecting a number of computing systems with one another or to another server computer. Further, the I/O interface(s) 106 may include one or more ports for connecting a number of devices to one another or to another server.

The one or more hardware processors 104 may be implemented as one or more microprocessors, microcomputers, microcontrollers, digital signal processors, central processing units, state machines, logic circuitries, and/or any devices that manipulate signals based on operational instructions. Among other capabilities, the one or more hardware processors 104 are configured to fetch and execute computer-readable instructions stored in the memory 102. In the context of the present disclosure, the expressions 'processors' and 'hardware processors' may be used interchangeably. In an embodiment, the system 100 can be implemented in a variety of computing systems, such as laptop computers, portable computer, notebooks, hand-held devices, workstations, mainframe computers, servers, a network cloud and the like.

The memory 102 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. In an embodiment, the memory 102 includes a plurality of modules 102a and a repository 102b for storing data processed, received, and generated by one or more of the plurality of modules 102a. The plurality of modules 102a may include routines, programs, objects, components, data structures, and so on, which perform particular tasks or implement particular abstract data types.

The plurality of modules 102a may include programs or computer-readable instructions or coded instructions that supplement applications or functions performed by the system 100. The plurality of modules 102a may also be used as, signal processor(s), state machine(s), logic circuitries, and/or any other device or component that manipulates signals based on operational instructions. Further, the plurality of modules 102a can be used by hardware, by computer-readable instructions executed by the one or more hardware processors 104, or by a combination thereof. Further, the memory 102 may include information pertaining to input(s)/output(s) of each step performed by the processor(s) 104 of the system 100 and methods of the present disclosure.

The repository 102b may include a database or a data engine. Further, the repository 102b amongst other things, may serve as a database or includes a plurality of databases for storing the data that is processed, received, or generated as a result of the execution of the plurality of modules 102a. Although the repository 102b is shown internal to the system 100, it will be noted that, in alternate embodiments, the repository 102b can also be implemented external to the system 100, where the repository 102b may be stored within an external database (not shown in FIG. 1) communicatively coupled to the system 100. The data contained within such external database may be periodically updated. For example, new data may be added into the external database and/or existing data may be modified and/or non-useful data may be deleted from the external database. In one example, the data may be stored in an external system, such as a Lightweight Directory Access Protocol (LDAP) directory and a Relational Database Management System (RDBMS). In another embodiment, the data stored in the repository 102b may be distributed between the system 100 and the external database.

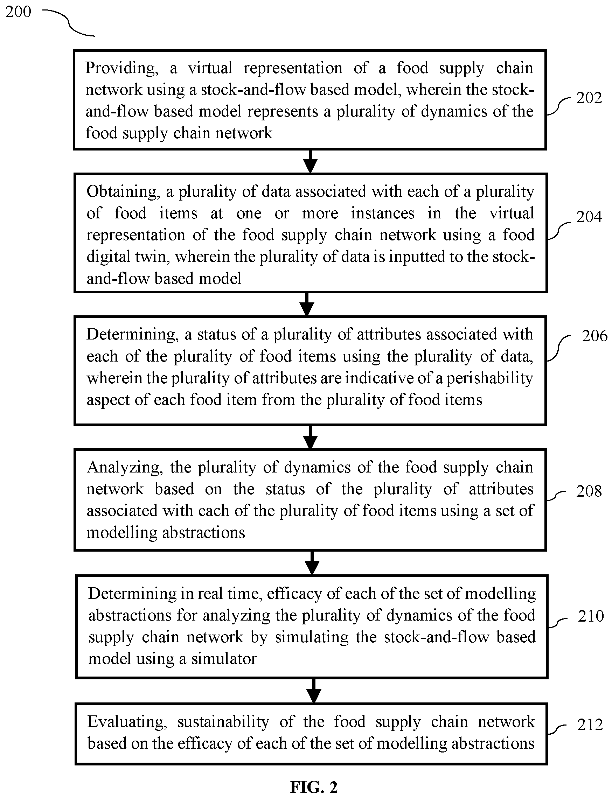

FIG. 2, with reference to FIG. 1, illustrates an exemplary flow diagram illustrating a method for evaluating sustainability of a food supply chain network using digital twin, using the system of FIG. 1, in accordance with some embodiments of the present disclosure.

Referring to FIG. 2, in an embodiment, the system(s) 100 comprises one or more data storage devices or the memory 102 operatively coupled to the one or more hardware processors 104 and is configured to store instructions for execution of steps of the method by the one or more processors 104. The steps of the method 200 of the present disclosure will now be explained with reference to components of the system 100 of FIG. 1, the flow diagram as depicted in FIG. 2, and one or more examples. Although steps of the method 200 including process steps, method steps, techniques or the like may be described in a sequential order, such processes, methods and techniques may be configured to work in alternate orders. In other words, any sequence or order of steps that may be described does not necessarily indicate a requirement that the steps be performed in that order. The steps of processes described herein may be performed in any practical order. Further, some steps may be performed simultaneously, or some steps may be performed alone or independently.

In an embodiment, at step 202 of the present disclosure, one or more hardware processors are configured to provide a virtual representation of a food supply chain network using a stock-and-flow based model. In the context of the present disclosure, the expressions 'food supply chain network ' and 'supply chain network' can be interchangeably used throughout the description. The plurality of dynamics of the food supply chain network comprises dynamics of storage, dynamics of transportation, and dynamics of retailer. The stock-and-flow based model represents a plurality of dynamics of the food supply chain network. The stocks in the stock-and-flow based model represents different types of storages, including warehouses, distribution centers (DCs), and retailers, while the flows in stock-and-flow based model depict the movements of food items (fruits in the present disclosure) between these storages using various transportation means. Spoilages from different locations and donations are also aligned with the flow semantics. In an embodiment, The stock-and-flow based model is alternatively referred as a coarse-grained stock-and-flow based system dynamics model.

In the context of the present disclosure, the food supply chain network is focused but not limited to a fruit supply chain network for climacteric fruits. Ripening of climacteric fruits, such as apple, banana, papaya, and mango, is a complex physicochemical phenomenon resulting in various physiological, biochemical, and developmental changes. They ripen after harvesting and continue $CO_2$ respiration and ethylene emission until they reach a climacteric peak. The climacteric peak, which represents an optimal edible ripeness, of a fruit is characterized by best characteristics including color, texture, flavor, aroma, and nutritional value. After this climacteric peak, fruits become more susceptible to fungal invasion and begin to de-grade quality through cell death, resulting in wastage. While these dynamics are primarily time-bound and unique for each fruit, they can be regulated through suitable preservation means, such as temperature control, edible coatings, and chemical treatments. The key challenges in this context are that the ideal edible ripeness phase is extremely short for most of these fruits, ripening can be controlled only to a certain extent considering various food safety regulations, and implementing controls through preservation means is associated with significant costs. Any mismatch in managing these factors can lead to wastage, economic losses and hindering the achievement of sustainable development goals (SDGs).

The key considerations of a fruit supply chain are to harvest the fruits at the appropriate time (with optimum remaining shelf life to reach the climacteric peak) and to channelize and preserve them throughout the supply chain. It is expected to meet several Key Performance Indicators (KPIs) in addition to traditional supply chain related KPIs, such as availability and profit margin. For example, the fruits need to be available to consumers during the ideal edible ripeness condition and optimize both business objectives and nutritional value while meeting industry standards, ensuring food safety, and supporting sustainable practices such as reducing wastage and maintaining an affordable price. Designing and maintaining an effective fruit supply chain that fulfills all desired criteria along multiple dimensions is a challenge. It requires a precise understanding of the characteristics of the fruit, along with possible dynamics and interventions at various phases, including harvesting, handling, preservation, transportation, distribution, and consumption.

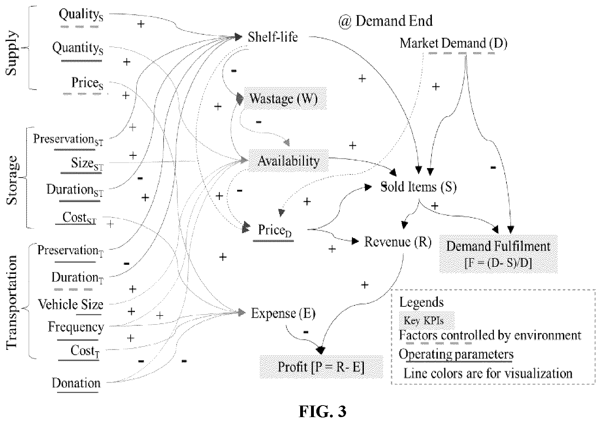

FIG. 3 illustrates high level dynamics and a plurality of factors having a prominent impact on Key performance indicators (KPIs) of the food supply chain network especially fruit supply chain network, in accordance with some embodiments of the present disclosure. Cultivation region, seasonality of the fruit, and the harvesting process contribute to the quality (i.e., $Quality_s$) and quantity (i.e., $Quantity_s$) of the supply. They also collectively influence the remaining shelf-life and availability of the fruits for rest of the phases, such as storage, transportation and distributions. Seasonality is another significant characteristic of the fruit supply chain. Many fruits have specific growing seasons, and the supply chain must adapt to these seasonal fluctuations in supply and demand. During the peak harvest periods, the supply chain must accommodate a surge in fruit volumes and efficiently manage the processing, packaging, and storage, along with distribution to meet immediate consumer demands. On the contrary, the supply chain may need to source fruits from different regions or rely on storage and preservation to ensure a consistent and high-quality fruit supply during off-seasons. Harvesting quantity, seasonality, and scarcity versus demand influence the purchase price of the fruit at the supply end, (i.e., $Price_s$). As depicted in FIG. 1, timely harvesting, transportation, and storage options, along with preservation techniques (i.e., $Preservation_{ST}$ and $Preservation_T$), play crucial roles in determining the quality and shelf-life of fruits at demand end. Key defining characteristics of the fruit supply chain include remaining shelf-life, perishability, and preservability, in addition to demand characteristics such as local or global demand volume. These factors collectively influence transportation and storage decisions, wastage rates, and price flexibility. Fruits with shorter shelf-life require better storage and transportation facilities to maintain their freshness and extend their shelf-life. Proper treatment of shelf-life related factors, such as temperature, humidity, and handling practices during storage and transportation, is essential to ensure an adequate supply of fruits for an extended period, reduce spoilage, minimize wastage, and enhance consumer satisfaction in response to demand.

The supply chain dynamics involve considerations of storage alternatives ($Size_S$ and $Preservation_S$), transportation means (with $Preservation_T$) and frequency, price point ($PriceD$), and market demand ($D$). The sophistication of storage treatments and timely temperature-controlled transportation ($Preservation_T$) options, along with transportation duration ($Duration_T$), increase operational costs but improve fruit quality and extend shelf-life. These operational costs inversely influence the price and demand, while better fruit quality boosts demand and customer satisfaction, ultimately leading to increased sales. As shown in FIG. 1, an alternate channel termed as Donation is considered, where fruits are given away at a reduced cost or free of charge at various phases of the supply chain. This approach supports novel causes and helps minimize wastage and reduce upstream operational costs. However, it also carries a risk of compromising revenue and availability, necessitating a careful tradeoff between achieving sustainability measures and maintaining profitability.

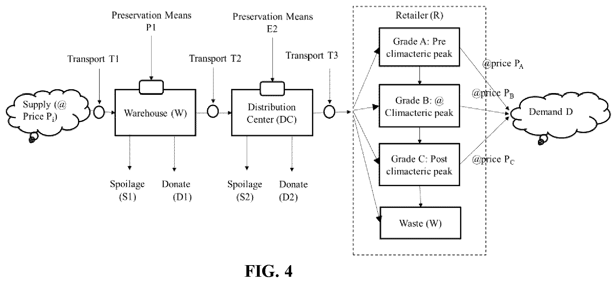

FIG. 4 illustrates a schematic view of the food supply chain network especially fruit supply chain network, in accordance with some embodiments of the present disclosure. As shown in FIG. 4, a conceptual framework for visualizing the fruit supply chain as a multi-stage network, encompassing harvesting locations as the supply source and distributed retailers at consumption locations as the demand endpoint is presented. As shown in FIG. 4, one or more harvesting regions are considered as supply for supply chain network. After harvesting, immediate post-harvest treatments such as cooling, temperature control, and management of $CO_2$ and ethylene emissions become critical to modulate the ripening process and preserve the freshness of the fruits. A strategic placement of warehouses equipped with suitable preservation means considering proximity of harvesting site and transportation options are essential. The use of temperature-controlled vehicles during transportation is imperative for maintaining freshness, mitigating ripening acceleration and reducing potential spoilage.

Moving towards the demand end, subsequent stage involves a network of distribution centers strategically designed to accommodate dynamics of consumer demand. Similar to warehouses, distribution centers (DCs) necessitate advanced storage facilities with effective preservation means, (e.g., temperature and humidity control), to extend the shelf-life of the fruits. Introducing controlled environment in tandem with well-designed transportation ensures that high-quality fruits progress through the supply chain network. Final stage of the supply chain network culminates at a network of retailers, where fruits are received with varying shelf-life grades, such as pre-climacteric peak (Grade A), climacteric peak (Grade B), and post-climacteric peak (Grade C). Retailers determine pricing based on condition of the fruits and the prevailing demand at specific locations and times. As fruits transition from one grade to another (e.g., from Grade A to Grade B, Grade B to Grade C, and Grade C to Wastage) rapidly during display to consumers at retail shops, retailers must adeptly adjust prices to manage revenue and profitability. Retailers aim to ensure that consumer demands are met while minimizing wastage and maintaining profitability.

Further, at the step 204 of the present disclosure, the one or more hardware processors are configured to obtain a plurality of data associated with each of a plurality of food items at one or more instances in the virtual representation of the food supply chain network using a food digital twin. The plurality of data is inputted to the stock-and-flow based model. The food digital twin (FDT) is an artificial intelligence based cloud-native internet of things (IoT) technology that possess soft-sensing capabilities. The (FDT) serves as a sensor to collect the plurality of data at various points within the food supply chain network.

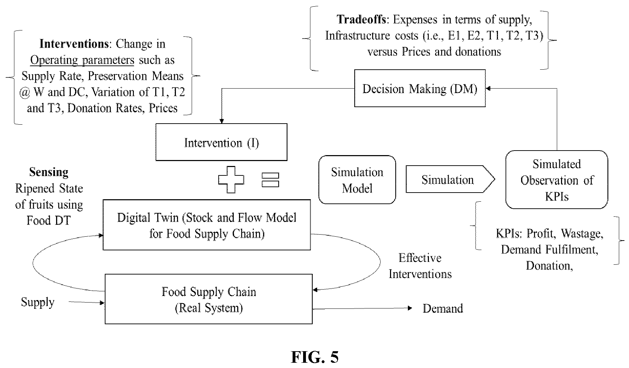

FIG. 5 illustrates an overview of the food digital twin and the food digital twin based design and exploration the food supply chain network especially fruit supply chain network, in accordance with some embodiments of the present disclosure. As evident from schematic view of the food supply chain network of FIG. 4, and in consideration of non-linear complexities depicted in FIG. 3, efficiency and effectiveness of a climacteric fruit supply chain chiefly rely on making effective design choices and introducing timely interventions at various stages of the supply chain. These measures are crucial to precisely manage the challenges posed by perishability, optimize food availability, minimize wastage, and ensure consumer satisfaction. To address these challenges, the concept of using the food a digital twin is used as an experimentation aid as shown in FIG. 5, serving two main purposes: a) exploring design options such as warehouse and distribution network configurations and suitable vehicle selection, and b) introducing effective interventions including deciding supply rate, temperature control and other treatments at warehouses, distribution centers, and during transportation.

At the step 206 of the present disclosure, the one or more hardware processors are configured to determine a status of a plurality of attributes associated with each of the plurality of food items using the plurality of data. Various decision factors that influence the movement of a food item correspond to semantics of auxiliary variables. While the storage and flow dynamics of fruit aggregated quantity align well with system dynamics paradigms, the perishability aspect, encompassing food quality and remaining shelf-life based on storage and transportation conditions, adds an additional layer of complexity. The plurality of attributes are indicative of a perishability aspect of each food item from the plurality of food items. The plurality of attributes comprises a ripening state and remaining shelf-life of each food item from the plurality of food items. The soft-sensing capability of the FDT is utilized to monitor, and predict physical conditions of fruits at various points within the supply chain, including warehouses, DCs, during transitions, and with the retailers. The status of the plurality of attributes associated with each of the plurality of food items indicate if the food items are in a perishable stage or a non-perishable stage, thereby monitor the freshness of the food item.

At step 208 of the present disclosure, the one or more hardware processors are configured to analyze the plurality of dynamics of the food supply chain network based on the status of the plurality of attributes associated with each of the plurality of food items using a set of modelling abstractions. The dynamics of storage is analyzed based on a computed quantity of storage stock, an aggregated remaining shelf-life, a spoilage rate, a purchase rate, one or more variables representing storage-to-storage movements, one or more cost associated factors, and a donation parameter at one or more storage points. The one or more variables representing storage-to-storage movements include inflows and outflows. The one or more cost associated factors may include but are not limited to a purchase cost. The dynamics of transportation is analyzed based on type of vehicles, frequency of the vehicles, temperature control capability and the cost associated with the vehicles used for transportation. The dynamics of retailer is analyzed based a grade distribution, grade flow and demand distribution of the plurality of food items at one or more retailer points.

The step 208 is better understood by way of the following description provided as exemplary explanation.

The continuation of the ripening process of fruits while they are in warehouses, distribution centers, with retailers, or during transportation, and its influence from various preservation means, e.g., temperature control, adopted at various storage and transportation facilities, show non-linear dynamics. For example, the ripening stage (i.e., remaining shelf-life) influences the feasibility of storing fruits for specific durations and transporting them using specific means, while the duration of storage and transportation, in turn, affects the remaining shelf-life of the fruits. To precisely represent and analyze these non-linear dynamics, three modelling abstraction for: a) dynamics of storages, such as warehouses and distribution centers, b) dynamics of transportation or flow, and c) dynamics of retailers, as retailers have more complex dynamics compared to warehouses and distribution centers are introduced. Conceptually, these three modelling abstractions introduce perishability dynamics (i.e., remaining shelf-life) in conjunction with traditional dynamics representing stock and flow of quantities.

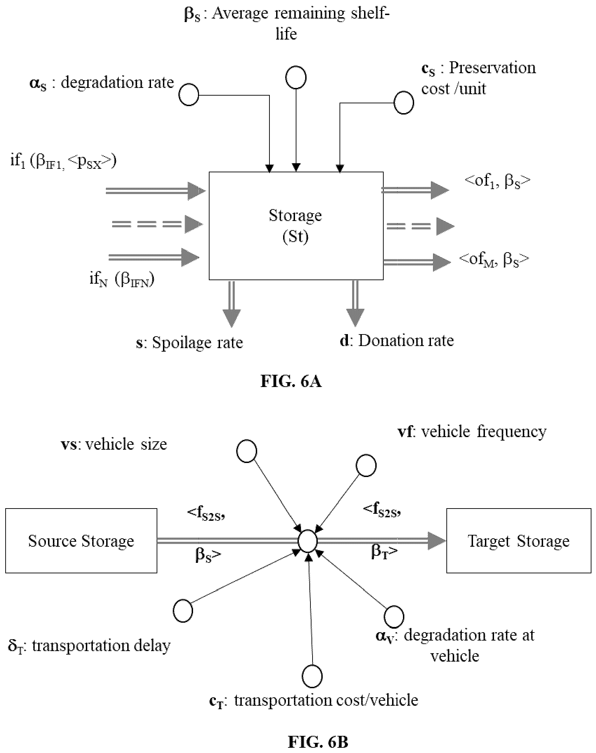

FIGS. 6A through 6C provide schematic overview illustrating the plurality of dynamics of the food supply chain network especially fruit supply chain network, in accordance with some embodiments of the present disclosure. FIG. 6A provides a schematic overview illustrating dynamics of storage of the food supply chain network especially fruit supply chain network, in accordance with some embodiments of the present disclosure. Primarily, the fruits are collected from harvesting sites and transported to nearest warehouse for better preservation. They are further transported to other warehouses and DCs based on size and topology of the supply chain. The warehouses may form a network, serving different purposes, such as facilitating quick access to farming sites and large warehouses equipped with advanced preservation means to store fruits for extended periods. Similarly, the DCs may have diverse networks, including central, regional, and local distribution centers, aiming to reach retailers conveniently. Despite their different objectives, each node of these networks termed as storage ($S$) that represents a warehouse or a DC, shares two common characteristics: a) it acts as storage units to collect, store, and distribute a large volume of fruits for extended time, and b) it aims to preserve shelf-life by considering the perishability dynamics of the specific fruit. These storages are conceptualized as an extended form of stocks by comprehending two interrelated aggregated dynamics: fruit flow dynamics that influence the quantity of the storage stock ($S_t$) and the perishability dynamics of the fruits in terms of the aggregated remaining shelf-life ($\beta$) as shown in FIG. 6A.

The quantity of the storage stock ($S_t$) is computed using the conventional differential equation of the stock-and-flow model, where the inflows include the flow of fruits reaching storage from various sources. Here, N inflows represented as $If_i$, where $i = 1..N$ are considered for each sourcing aggregated shelf-life $\beta_i$ respectively. For warehouses, these inflows are purchase flows from different harvesting sites ($f_{SX}$) which comes with purchase cost ($p_{SX}$), as shown in FIG. 6A and the outflows from other warehouses ($f_{W2W}$), whereas for distribution centers, the inflows typically include the outflow from warehouses ($f_{W2DC}$) and outflows from other distribution centers ($f_{DC2DC}$).

The storage outflows, shown as $M$ outflows represented as $Of_j$, where $j = 1..M$, in FIG. 6A, of a warehouse consist of collective fruit flows from the warehouse to other ware-houses ($f_{W2W}$), from warehouses to distribution centers ($f_{W2DC}$), the spoilage rate ($s$), and the donation parameter (alternatively referred as fruit donation rate) ($d$) from the storage unit. Typical outflows of distribution centers (i.e., $Of_j$, $j = 1..M$) are the flow to the other distribution centers ($S_t$) and flow to the retailers ($f_{DC2R}$) in addition to the spoilage rate ($s$) and the donation parameter ($d$).

The aggregated perishability dynamics of the fruits stored in a storage unit depend on an average remaining shelf-life ($\beta_s$) of the fruits in the storage ($S_t$), the average remaining shelf-life of all inflows ($\beta_{If_i}$), and a degradation rate at the storage ($\alpha_S$). The dynamics of the aggregated remaining shelf-life of the fruits is specified as using equation (1) shown below:

$$\beta_{(t+1)} = \left(\sum\nolimits_{i=1..N}\left(If_i * \beta_{If_i}\right) + \beta_{(t)} * (1 - \alpha_S) + S_t\right)/\left(\sum\nolimits_{i=1..N} If_i + S_t\right) \ (1)$$

Here, $\beta_{(t+1)}$ and $\beta_{(t)}$ represent the average remaining shelf-life of fruits in the storage at time ($t + 1$) and time ($t$), respectively. $If_i$ represents the inflows to the stock and $\beta_{If_i}$ represents corresponding average remaining shelf-life of the fruits when they enter into the storage. $\alpha_S \in [0..1]$ represents the degradation rate of the fruit, where value '0' indicates no degradation and value '1' indicates sudden wastage due to environmental factor. The $\alpha_S$ can be controlled through appropriate preservation means by spending cost ($c_S$).

In storage dynamics, the spoilage rate ($s$) at a warehouse or distribution center is a physical phenomenon typically influenced by size of the storage, internal arrangements for shelving fruits, handling of fruits, and other environmental factors. The FDT is used to determine and estimate the spoilage rate, and the estimated value is then provided into the stock-and-flow based model as a parameter value. On the other hand, the purchase rate ($f_P$) and other storage-to-storage movements are considered as interventions, represented using auxiliary variables to enable what-if explorations.

For a warehouse, key decision points and tradeoffs involve the purchase rate ($f_P$), balancing the purchase quality with better remaining shelf-life $\beta_P$ against the purchase cost ($p_{SX}$), optimizing the degradation rate ($\alpha$) through better environmental control with respect to the preservation cost ($c$), and managing the stock at the storage $S_t$ versus the donation rate ($d$). Similarly, the decision points and tradeoffs at distribution centers include determining the degradation rate by paying different preservation costs and managing the donation rate.

FIG. 6B provides a schematic overview illustrating dynamics of transportation of the food supply chain network especially fruit supply chain network, in accordance with some embodiments of the present disclosure. In a canonical stock-and-flow based model, the quantity of items flows from one stock to another, and the rate of flow is computed by various control variables represented using auxiliary variables. In the context of the food supply chain, fruits flow from one storage to another, and the rate of flow is primarily determined by the decision factors, such as type of vehicles used and their frequencies. However, in addition to this dynamic, there are additional complexities related to perishability, where the aggregated remaining shelf-life at the destination ($\beta_T$) differs from the aggregated remaining shelf-life at the source ($\beta_S$) as shown in FIG. 6B. For instance, transportation delay for a vehicle ($V$) with a vehicle size $v_s$ is considered where the transportation delay is denoted as $\delta_{ST}$, the degradation rate of the fruits while transporting fruits with the vehicle $V$ is denoted as $\alpha_V$, and frequency of vehicle $V$ is denoted as $v_F$. Then, flow equation and shelf-life computation for vehicle $V$ are shown below in equations (2) and (3) respectively as:

$$f_{S2S} = O_{\delta_T}(v_S * v_F) \ (2)$$

$$\beta_T = \beta_S - (\delta_T * \alpha_V) \ (3)$$

In an embodiment, in the supply chain network, there could be several vehicle types with different sizes $v_S$, speeds that influence transportation delay $\delta_{ST}$ and the degradation rate $\alpha_V$, for which incurring vehicle costs $c_T$ are involved. Here, different vehicle types can be seen as different flow types between source and target storages. The key tradeoff factors in this context are type, size, frequency, and temperature control capability of the vehicles versus the cost associated with them.

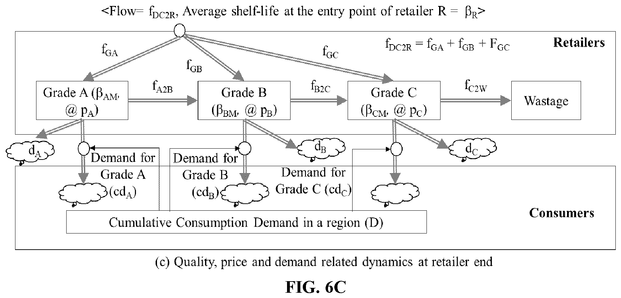

FIG. 6C provides a schematic overview illustrating dynamics of retailer of the food supply chain network especially fruit supply chain network, in accordance with some embodiments of the present disclosure. Retailers deal with most complex and uncertain situations in the entire fruit supply chain network. On one hand, they need to manage optimum flow of fruits to meet consumer demand (i.e., optimum replenishment), and on the other hand they have to consistently monitor the quality/freshness of the fruits that they receive from distribution center, grade them into multiple buckets and decide appropriate pricing for each grade so as to enhance consumer satisfaction by offering quality-based pricing, and reduce wastage without compromising profitability. As shown in FIG. 6C, it is considered that a retailer $R$ receives fruits from distribution centers at rate $f_{DC2R}$ with average remaining shelf-life $\beta_R$, an ideal shelf-life of the fruit under consideration is $\beta_I$ (i.e., climacteric peak of the fruit) and estimated demand of the fruit at retailer $R$ is $D$ which may differ over days and months of the year. Further, it is considered that the retailer $R$ decides three grades for introducing quality-based pricing, where *Grade A* refers fruits with pre-climacteric stage, *Grade B* is ideal stage (i.e., around climacteric peak) with the best nutritional value and visual appearance, and *Grade C* is fruits in post climacteric stage but not spoiled yet. Formally, $\beta_{AL}$, $\beta_{BL}$, and $\beta$CL are considered as lower threshold remaining shelf-life values of *Grade A, Grade B,* and *Grade C* respectively. Therefore, the shelf-life of *Grade A* is [100, $\beta_{AL}$], the shelf-life of *Grade B* is ($\beta_{AL}$, $\beta_{BL}$], and the shelf-life of *Grade C* is ($\beta_{BL}$, $\beta_{CL}$]. Further, $\beta_{AM}$, $\beta_{BM}$, and $\beta_{CM}$ are considered as median remaining shelf-life values of *Grade A, Grade B,* and *Grade C* respectively. It is noted that $\beta_{BM}$ should be close to $\beta_I$, if not the same value is referred. Ideally, retailer can decide any number of grades, but 3 grades are considered in the present disclosure.

While rate at which retailer $R$ receives fruits from distribution center (i.e., $f_{DC2R}$), is relatively easy to control, the remaining shelf-life $\beta_R$ is difficult to control as it varies based on the purchase quality and down-stream preservation means applied. Therefore, the internal distribution of inflows (termed as grade distribution) from the entry point of retailer to *Grade A, Grade B* and *Grade C* is not known precisely. There are other complexities at the retailer end. There are continuous flows of fruits (termed as grade flows) from *Grade A* to *Grade B, Grade B* to *Grade C*, and *Grade C* to Wastage. Notably, these flows cannot be controlled much as they follow standard degradation ($\alpha_L$) based on normal temperature and other local environmental factors. Controlling degradation rate at retailer end is often operationally infeasible. Another complexity is demand-distribution for *Grade A, Grade B* and *Grade C* from total demand $D$. They are dependent on grade prices ($p_A$, $p_B$ and $p_C$), in addition to food value of each grade. In the present disclosure, three estimator functions described below are used to represent these interrelated dynamics.

**Grade distribution:** It is considered that distribution of inflowed fruits with average shelf-life $\beta_R$ to *Grade A, Grade B,* and *Grade C* is inversely proportional to the distance of the median shelf-life of respective grades from $\beta_R$. In other words, the distribution of $f_{GA}$, $f_{GB}$, and $f_{GC}$ from the total inflow $f_{DC2R}$ is proportional to $f_{pA}$, $f_{pB}$, and $f_{pC}$, where, as shown in equation (4) below:

$$\langle f_{pA} : f_{pB} : f_{pC} \rangle = \langle 1/(|\beta_R - \beta_{AM}|) : 1/(|\beta_R - \beta_{BM}|) : 1/(|\beta_R - \beta_{CM}|) \rangle \ (4)$$

**Grade Flow:** A conventional stock and flow principle is used for decay function to define grade-related flows. The flows from *Grade A* to *Grade B, Grade B* to *Grade C,* and *Grade C* to Wastage are defined as $1/(|\beta_{AM} - \beta_{BM}|)$, $1/(|\beta_{BM} - \beta_{CM}|)$, $1/|\beta_{CM}|$ respectively. Essentially, the decay flow is proportional to difference of two median shelf-life.

**Demand distribution:** Estimating the demand for a type of fruits in a retail shop depends on several factors, including the region, proximity to other retail shops, the track record of fruit quality at the shop, season, and other socio-economic factors. In the present disclosure, it is assumed that overall demand for a specific fruit at a retailer is known and represented as $D$. The key challenge is estimating the demand distribution of various grades. While this distribution may also depend on socio-economic situations and other demographic factors, for simplicity, the demand distribution is approximated based on the grade quality (derived from the grade definition) and grade prices. The proportion of demand distribution for *Grade A, Grade B,* and *Grade C* is defined as shown in equation (5) below:

$$\langle c_{dA}: c_{dB}: c_{dC}\rangle = \langle 1/\left(|\beta_I - \beta_{AM}|^{\phi_1} * p_A{}^{\phi_2}: \langle\left(|\beta_I - \beta_{BM}|^{\phi_1} * p_B{}^{\phi_2}: \langle 1/\left(|\beta_I - \beta_{CM}|^{\phi_1} * p_C{}^{\phi_2}\rangle \quad (5)$$

Essentially, the proportions are inversely proportional to weighted value ($\phi_1$) of average degraded remaining shelf-life from the ideal condition ($\beta_I$), and weighted value ($\phi_2$) of grade price. $\phi_1$ and $\phi_2$ are introduced to represent affinity for quality and price, which may differ based on individual customers and/or personas. Here, it is assumed that consumers are more sensitive to price than quality.

Referring back to FIG. 2, at step 210 of the present disclosure, the one or more hardware processors are configured to determine in real time, efficacy of each of the set of modelling abstractions for analyzing the plurality of dynamics of the food supply chain network by simulating the stock-and-flow based model using a simulator. The simulator is a Vensim® simulator with a pySD® module that is used to test various interventions related to combination of food wastage, donation, strategic pricing, and transportation.

Further, at step 212 of the present disclosure, the one or more hardware processors are configured to evaluate sustainability of the food supply chain network based on the efficacy of each of the set of modelling abstractions. The Vensim® simulator with the pySD® module is used to evaluate as-is or potential to-be supply chain, with or without interventions, for in-silico experimentation to gain insights into the efficacy of potential design choices and interventions.

The steps 210 and 212 are better understood by way of the following description provided as exemplary explanation.

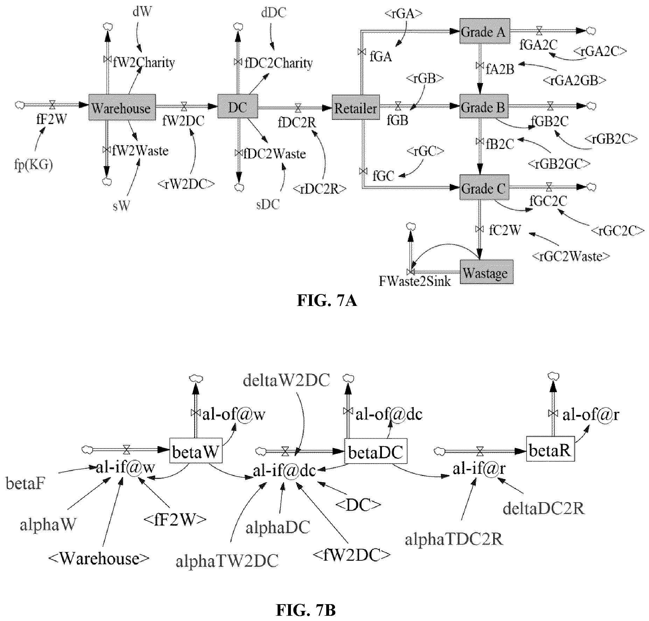

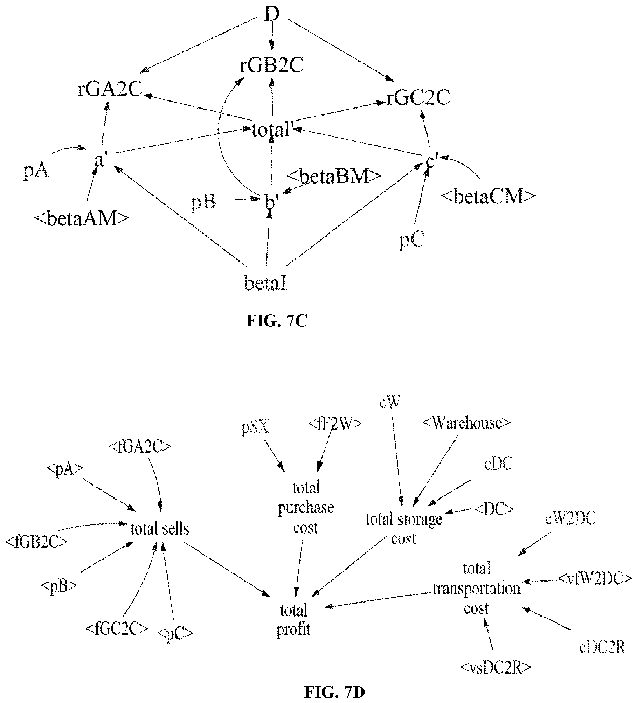

The set of modeling abstractions including storage, transportation, and retailer abstractions are used to model a network of hierarchical or non-hierarchical warehouses and DCs with retailers at the consumer end to represent the food supply chain network. For concrete model realization, two connected stocks are used: i) A primary stock that represents quantity and quantity flows, and ii) a shadow stock that mimics the quantity of the primary stock and computes the remaining shelf-life, (i.e., perishability dynamics). To implement the food supply chain network, The Vensim® along with PySD® module is used. FIGS. 7A through 7D depict an illustrative food supply chain network with one supply site, one warehouse, one distribution center, and one retailer respectively using a Vensim® model, in accordance with some embodiments of the present disclosure. FIG. 7A shows the primary stocks and their flows, along with donations and spoilages from different stages using the Vensim® model, in accordance with some embodiments of the present disclosure. As shown in FIG. 7A, conventional fruit movements between grades at the retailer end are illustrated. FIG. 7B describes the shadow stocks and their perishability dynamics using the Vensim® model, in accordance with some embodiments of the present disclosure. FIG. 7C illustrates a realization of the demand distribution logic using the Vensim® model, in accordance with some embodiments of the present disclosure. FIG. 7D illustrates computation of economic aspect of the supply chain network, which is an arithmetic computation module that uses auxiliary variables representing various costs at various stages of the supply chain network using the Vensim® model, in accordance with some embodiments of the present disclosure. As shown in FIG. 7D, revenue and profits are calculated based on the costs allocated for purchase, transportations and preservation means at warehouses and DCs.

The soft-sensing capabilities of the food digital twin (FDT) are utilized to sense, monitor, and predict the physical conditions of fruits at various points within the supply chain, including warehouses, DCs, during transitions, and with the retailers. As shown in FIG. 5, the FDT serves as a bridge between t representative model and reality, providing crucial real-time insights of the fruits through auxiliary variables (i.e., through PySD®) for timely interventions if any deviations from expected conditions happen in reality.

The Vensim® simulator of the food supply chain digital twin facilitates simulation of both as-is and to-be models of the supply chain, with and without interventions. PySD® allows inputting auxiliary parameters through a custom user interface and/or integration with the FDT. The FDT provides real-time sensing, ensuring food quality, food safety, and eliminating blind spots in the food supply chain. Table 1 below provides prospective scenarios that can be explored using the FDT.

Table 1

| Aspect | Parameters (Auxiliary variables) to explore) | Description |
|---|---|---|
| Supply | Purchase rate ($f_{SX}$), price ($p_{SX}$) and remaining shelf-life ($\beta_{SX}$) | Exploration: Different $f_{SX}$, < moderate $p_{SX}$ and moderate $\beta_{SX}$ > versus < high $\beta_{SX}$ and high $\beta_{SX}$ >.<br>Design: setting up warehouse close to harvesting site for better $\beta_{SX}$. |
| Storages: Warehouse and DC | Preservation cost ($c$), degradation rate ($\alpha$), Donation rate ($d$) | Exploration: Better $\alpha$ by paying more $c$, donate a part of stock.<br>Design: Add, shift or remove warehouses and/or distribution centers. |
| Transport | Vehicle size ($v_S$), frequency ($v_f$), speed ($\delta_T$), degradation rate ($\alpha_T$), and vehicle cost ($c_T$). | Exploration: increase or decrease frequency of specific vehicle ($v_f$).<br>Design: Different vehicle type with different $v_S$, $\delta_T$, $\alpha_T$ and associated cost/vehicle $c_T$. |
| Retailer | Grade definition (i.e., $\beta_{AL}$, $\beta_{BL}$, and $\beta_{CL}$) and price for different grades (i.e., $p_A$, $p_B$, and $p_C$) | Exploration: price for different grades ( i.e., $p_A$, $p_B$, and $p_C$).<br>Design: new grade definition with different < $\beta_{AL}$, $\beta_{BL}$, $\beta_{CL}$ > and < $\beta_{AM}$, $\beta_{BM}$, $\beta_{CM}$ > |

As observed from Table 1, multiple scenario simulations involving various design choices and interventions helps to gain valuable insights into the effectiveness of these strategies aiding informed decision-making aimed at optimizing the perishable fruit supply chain.

In India, various apple varieties including Red Delicious, Golden Delicious, and Royal Delicious are cultivated, primarily in the hilly regions of the northern states as they have favorable climatic conditions, such as cool temperatures and sufficient rainfall. Typically, these apples have a shelf-life of about 2 to 4 months when stored appropriately in cold storage facilities with controlled temperatures around 0 degrees Celsius and humidity levels of 85-90%. Despite the considerable demand for apples both within India and globally, there is significant wastage reported at various stages, including harvesting, transportation, storage, and distribution. To address this issue, it is crucial to improve post-harvest management practices, enhance transportation and storage facilities, and implement more effective supply chain management strategies. These measures are essential to minimize wastage and ensure that consumers have access to fresh and high-quality apples throughout the year. As part of a management course, an in-depth experiment to explore various intervention and design possibilities for the apple supply chain is conducted using the method of the present disclosure.

Experimental details:

In an embodiment, experimental details demonstrating technical art-possibilities and efficacy instead of focusing on business aspects of the method of present disclosure are provided. Table 2 below provide exploration details:

| 1 | | Exp* |
|---|---|---|
| Decreasing $\alpha_{DC}$ by increasing preservation cost $c$ at DC | Base configuration | Description |
| 10000 | 10000 | $f_P(KG)$ |
| 0 | 0 | $d_W$ |
| 0 | 0 | $d_{DC}$ |
| 175 | 175 | $p_A$ |
| 200 | 200 | $p_B$ |
| 100 | 100 | $p_C$ |
| 1 | 1 | $c_W$ |
| **2** | 1 | $c_{DC}$ |
| 1000 | 1000 | $c_{W2DC}$ |
| 1000 | 1000 | $c_{DC2R}$ |
| 0.02 | 0.02 | $\alpha_W$ |
| **0.01** | 0.04 | $\alpha_{DC}$ |
| 0.075 | 0.075 | $\alpha_{TW2DC}$ |
| 0.075 | 0.075 | $\alpha_{TDC2R}$ |
| 4 | 4 | $\delta_{W2DC}$ |
| 2 | 2 | $\delta_{DC2R}$ |

EP 4 567 692 A1

| |
|---|
| 2 |
| Decreasing $\alpha_T$ by increasing transportation cost $c_T$ at DC |
| 10000 |
| 0 |
| 0 |
| 175 |
| 200 |
| 100 |
| 1 |
| 1 |
| **1500** |
| **1500** |
| 0.02 |
| 0.04 |
| **0.05** |
| **0.05** |
| 4 |
| 2 |

| 4 | 3 |
|---|---|
| Decreasing Grade C price $p_C$ | Decreasing $\delta_T$ by increasing transportation cost $c_T$ on Exp2 |
| 10000 | 10000 |
| 0 | 0 |
| 0 | 0 |
| 175 | 175 |
| 200 | 200 |
| **75** | 100 |
| 1 | 1 |
| 1 | 1 |
| 1000 | **4000** |
| 1000 | **4000** |
| 0.02 | 0.02 |
| 0.04 | 0.04 |
| 0.075 | **0.05** |
| 0.075 | **0.05** |
| 4 | **2** |
| 2 | **1** |

| | | | | | | | | | | | | | | | | |
|---|---|---|---|---|---|---|---|---|---|---|---|---|---|---|---|---|
| 5 | Increasing Grade A and Grade B price | 10000 | 0 | 0 | **250** | 300 | 100 | 1 | 1 | 1000 | 1000 | 0.02 | 0.04 | 0.075 | 0.075 | 4 | 2 |
| 6 | Decreasing Purchase Rate | **8000** | 0 | 0 | 175 | 200 | 100 | 1 | 1 | 1000 | 1000 | 0.02 | 0.04 | 0.075 | 0.075 | 4 | 2 |
| 7 | Donating 2%stock/day from warehouse | 10000 | **0.02** | **0.02** | 175 | 200 | 100 | 1 | 1 | 1000 | 1000 | 0.02 | 0.04 | 0.075 | 0.075 | 4 | 2 |

| Exp | Description | | | | | | | | | | | | | | | | |
|---|---|---|---|---|---|---|---|---|---|---|---|---|---|---|---|---|---|
| 8 | Applying Exp6 & 7 | 8000 | 0.02 | 0.02 | 175 | 200 | 100 | 1 | 1 | 1000 | 1000 | 0.02 | 0.04 | 0.075 | 0.075 | 4 | 2 |
| 9 | Increasing donation on top Exp8 | 8000 | 0.04 | 0.04 | 175 | 200 | 100 | 1 | 1 | 1000 | 1000 | 0.02 | 0.04 | 0.075 | 0.075 | 4 | 2 |
| 10 | Applying Exp5 & 9 | 8000 | 0.04 | 0.04 | 250 | 300 | 100 | 1 | 1 | 1000 | 1000 | 0.02 | 0.04 | 0.075 | 0.075 | 4 | 2 |
| 11 | Applying Exp2, 5 & 6 | 8000 | 0 | 0 | 250 | 300 | 100 | 1 | 1 | 1500 | 1500 | 0.02 | 0.04 | 0.05 | 0.05 | 4 | 2 |

Table 2

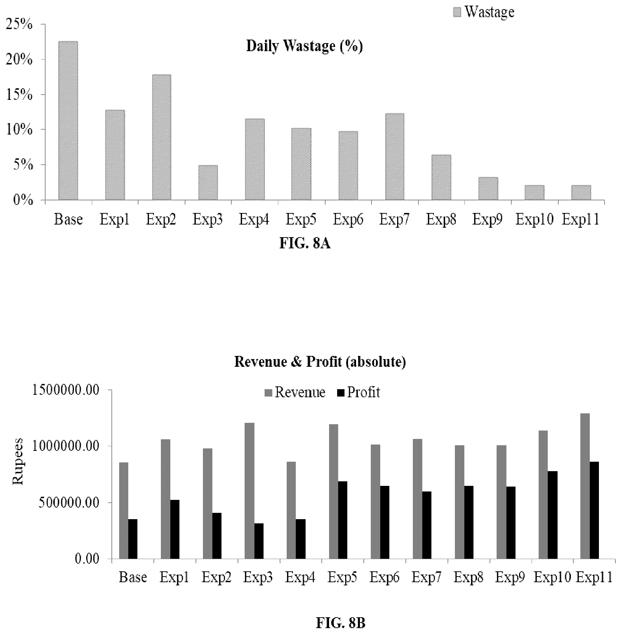

In an embodiment, the simulator which is a system dynamics simulation model realized using Vensim® is employed to explore impact of various parameters (e.g., auxiliary variables) as shown in Table 2 and key performance indicators (KPIs) that include wastage, revenue and profit margin, demand fulfilment and distribution of grades (i.e., quality) are observed. The key parameters include purchase rate ($f_P$), degradation rate at warehouse ($\alpha_W$), degradation rate at DC ($\alpha_{DC}$), degradation rate while transiting warehouse to DC ($\alpha_{TW2DC}$), degradation rate while transiting from DC to retailer ($\alpha_{TDC2R}$), preservation costs at warehouse and DC (i.e., $c_w$ and $c_{DC}$), unit vehicle costs from warehouse to DC ($c_{w2DC}$) and DC to retailer ($c_{CDC2R}$), unit price of *Grade A, Grade B* and *Grade C* (i.e., $p_A$, $p_B$, and $p_C$) and donation rates from warehouse ($d_W$) and distribution center ($d_{DC}$). Using the developed Vensim® simulator with the PySD® module, a baseline is defined with known parameters for validation and explored possible interventions, as shown in Table 2. FIGS. 8A though 8D depict graphical representations illustrating experimental results for evaluating sustainability of a food supply chain network using digital twin, in accordance with some embodiments of the present disclosure. The simulator enabled observing the effects of the known parameters on the KPIs as shown in FIGS. 8A though 8D.

**Explorations:**

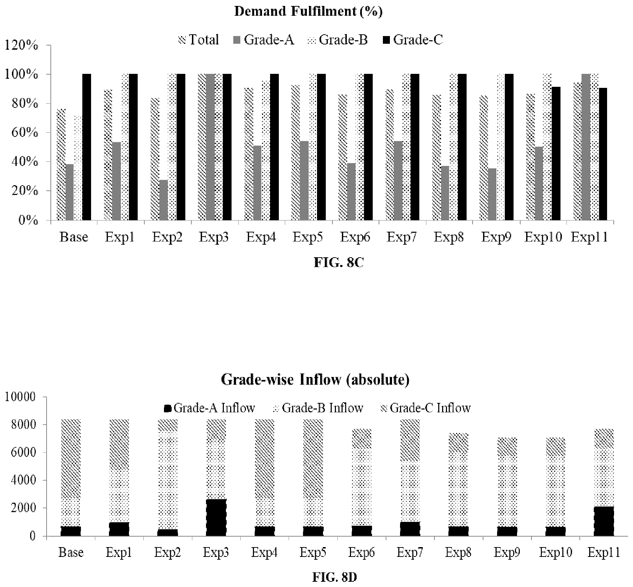

It is shown in FIG. 8A that a significant wastage is noticed in the baseline. Further, a low fulfillment ratio for high quality fruits, (i.e., *Grade A* and *Grade B*) is shown in FIG. 8C. A high inflow of *Grade C* apples impacting overall fruit quality (hence consumer satisfaction) and shelf life at the retailer is shown in FIG. 8D. As shown in FIG. 8B, the baseline scenario also indicates low to moderate revenue and profit. To improve this situation, there is focus on the degradation rate at the DC ($\alpha_{DC}$) with improved preservation means and therefore the cost ($c_{DC}$) is increased from 1 Rupee/Kg to 2 Rupees/Kg. This intervention led to a better distribution across grades, resulting in reduced daily wastage from 23% to 13% as shown in FIG. 8A. Additionally, as shown in FIG. 8C, overall demand fulfillment increased from 76% to 90%. As shown in FIG. 8B, both revenue and profit grew by 24% and 50% respectively compared to the baseline situation. In experiment 2, an impact of better degradation rates in transportation is explored. There, a slight improvement in daily wastage (from 23% in the baseline to 18%) is observed. However, it was found to be less effective than experiment 1, which means investing more on storage is more rewarding than transportation. Experiment 3 explored the impact of a high-speed vehicle option with higher transportation costs. While it indicated less wastage, a better demand fulfillment ratio, and improved shelf-life at the retailer, profitability became a concern. In experiments 4 and 5, the impacts of grade-specific prices on the baseline is explored. In experiment 4, it is found that reducing the price of low-grade (i.e., *Grade C*) fruit may not lead to a better situation in terms of demand fulfillment and profit-ability. Rather, exploring an optimum price for better quality fruits (i.e., *Grade A* and *Grade B*) could lead to a better outcome, as shown in experiment 5. Experiment 6 is an exploration of the purchase rate on the baseline. The experiment indicates a positive outcome, but it requires further exploration to arrive at the optimum purchase rate for a demand. Similarly, experiment 7 focuses on donations from warehouses and distribution centers. A comparative study of KPIs of the experiment 7 with respect to the baseline shows significant reduction in the wastage and better profitability. This indicates that donating fruits at the right time may help improve business KPIs while addressing sustainability goals.

Embodiments of the present disclosure present a food supply chain digital twin to design, configure and control the climacteric fruit supply chain, with broader implications for perishable food supply in general. The present disclosure delved into complexities of the supply chain, where fruits undergo various storage and transportation processes with their shelf-life playing a critical role in overall quality and wastage. To prioritize food quality in addition to availability and profitability, an extended form of the stock-and-flow based model is developed, encompassing two aggregated dynamics: fruit flow dynamics impacting stock quantity, and perishability dynamics represented by aggregated remaining shelf-life. Further, three pragmatic and feasible modeling abstractions are used to represent different types of storages, flows, and retailer dynamics, and effectively utilized system dynamics model, an established enterprise modeling technique, to realize food supply chains digital twin. Experiments performed in the present disclosure using the food supply chain digital twin demonstrate the efficacy of the method of the present disclosure and modeling abstractions in comprehending the dynamics of the perishable fruit supply chain. By identifying crucial factors influencing its performance, the food digital twin provides valuable insights for supply chain managers, aiding them in making informed decisions to enhance efficiency, minimize wastage, and ensure availability of fresh, high-quality fruits for consumers. The stock-and-flow based model and food digital twin is further aimed to be refined for incorporating regional demand variations and socio-economic factors to develop more targeted and efficient supply chain management strategies. From technical perspective, while the stock-and-flow based model is found to be feasible option for realizing a food digital twin, it has significant accidental complexity. More intuitive and easy-to-use enterprise modeling technique are explored in the present disclosure to enhance overall sustainability and profitability of food distribution system for enterprises and society

The written description describes the subject matter herein to enable any person skilled in the art to make and use the embodiments. The scope of the subject matter embodiments is defined herein and may include other modifications that occur to those skilled in the art. Such other modifications are intended to be within the scope of the present disclosure if they have similar elements that do not differ from the literal language of the embodiments or if they include equivalent elements with insubstantial differences from the literal language of the embodiments described herein.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated herein by the following claims.

## Claims

1. A processor implemented method (200), comprising:

   providing (202), via one or more hardware processors, a virtual representation of a food supply chain network using a stock-and-flow based model, wherein the stock-and-flow based model represents a plurality of dynamics of the food supply chain network;
   obtaining (204), via the one or more hardware processors, a plurality of data associated with each of a plurality of food items at one or more instances in the virtual representation of the food supply chain network using a food digital twin, wherein the plurality of data is inputted to the stock-and-flow based model,
   determining (206), via the one or more hardware processors, a status of a plurality of attributes associated with each of the plurality of food items using the plurality of data, wherein the plurality of attributes are indicative of a perishability aspect of each food item from the plurality of food items;
   analyzing (208), via the one or more hardware processors, the plurality of dynamics of the food supply chain network based on the status of the plurality of attributes associated with each of the plurality of food items using a set of modelling abstractions;
   determining in real time (210), via the one or more hardware processors, efficacy of each of the set of modelling abstractions for analyzing the plurality of dynamics of the food supply chain network by simulating the stock-and-flow based model using a simulator; and
   evaluating (212), via the one or more hardware processors, sustainability of the food supply chain network based on the efficacy of each of the set of modelling abstractions.

2. The processor implemented method as claimed in claim 1, wherein the plurality of dynamics of the food supply chain network comprises dynamics of storage, dynamics of transportation, and dynamics of retailer.

3. The processor implemented method as claimed in claim 1, wherein the plurality of attributes comprises a ripening state and remaining shelf-life of each food item from the plurality of food items.

4. The processor implemented method as claimed in claim 1, wherein the dynamics of storage is analyzed based on a computed quantity of storage stock, an aggregated remaining shelf-life, a spoilage rate, a purchase rate, one or more variables representing storage-to-storage movements, one or more cost associated factors, and a donation parameter at one or more storage points.

5. The processor implemented method as claimed in claim 1, wherein the dynamics of transportation is analyzed based on type of vehicles, frequency of the vehicles, temperature control capability and the cost associated with the vehicles used for transportation.

6. The processor implemented method as claimed in claim 1, wherein the dynamics of retailer is analyzed based a grade distribution, grade flow and demand distribution of the plurality of food items at one or more retailer points.

7. A system (100), comprising:

> a memory (102) storing instructions;
> one or more communication interfaces (106); and
> one or more hardware processors (104) coupled to the memory (102) via the one or more communication interfaces (106), wherein the one or more hardware processors (104) are configured by the instructions to:

>> provide a virtual representation of a food supply chain network using a stock-and-flow based model, wherein the stock-and-flow based model represents a plurality of dynamics of the food supply chain network;
>> obtain a plurality of data associated with each of a plurality of food items at one or more instances in the virtual representation of the food supply chain network using a food digital twin, wherein the plurality of data is inputted to the stock-and-flow based model;
>> determine a status of a plurality of attributes associated with each of the plurality of food items using the plurality of data, wherein the plurality of attributes are indicative of a perishability aspect of each food item from the plurality of food items;
>> analyze the plurality of dynamics of the food supply chain network based on the status of the plurality of attributes associated with each of the plurality of food items using a set of modelling abstractions;
>> determine in real time, efficacy of each of the set of modelling abstractions for analyzing the plurality of dynamics of the food supply chain network by simulating the stock-and-flow based model using a simulator; and
>> evaluate sustainability of the food supply chain network based on the efficacy of each of the set of modelling abstractions.

8. The system as claimed in claim 7, wherein the plurality of dynamics of the food supply chain network comprises dynamics of storage, dynamics of transportation, and dynamics of retailer.

9. The system as claimed in claim 7, wherein the plurality of attributes comprises a ripening state and remaining shelf-life of each food item from the plurality of food items.

10. The system as claimed in claim 7, wherein the dynamics of storage is analyzed based on a computed quantity of storage stock, an aggregated remaining shelf-life, a spoilage rate, a purchase rate, one or more variables representing storage-to-storage movements, one or more cost associated factors, and a donation parameter at one or more storage points.

11. The system as claimed in claim 7, wherein the dynamics of transportation is analyzed based on type of vehicles, frequency of the vehicles, temperature control capability and the cost associated with the vehicles used for transportation.

12. The system as claimed in claim 7, wherein the dynamics of retailer is analyzed based a grade distribution, grade flow and demand distribution of the plurality of food items at one or more retailer points.

13. One or more non-transitory machine-readable information storage mediums comprising one or more instructions which when executed by one or more hardware processors cause:

> providing a virtual representation of a food supply chain network using a stock-and-flow based model, wherein the stock-and-flow based model represents a plurality of dynamics of the food supply chain network;

obtaining a plurality of data associated with each of a plurality of food items at one or more instances in the virtual representation of the food supply chain network using a food digital twin, wherein the plurality of data is inputted to the stock-and-flow based model;

determining a status of a plurality of attributes associated with each of the plurality of food items using the plurality of data, wherein the plurality of attributes are indicative of a perishability aspect of each food item from the plurality of food items;

analyzing the plurality of dynamics of the food supply chain network based on the status of the plurality of attributes associated with each of the plurality of food items using a set of modelling abstractions;

determining in real time efficacy of each of the set of modelling abstractions for analyzing the plurality of dynamics of the food supply chain network by simulating the stock-and-flow based model using a simulator; and

evaluating sustainability of the food supply chain network based on the efficacy of each of the set of modelling abstractions.

14. The one or more non-transitory machine-readable information storage mediums as claimed in claim 13, wherein the plurality of dynamics of the food supply chain network comprises dynamics of storage, dynamics of transportation, and dynamics of retailer.

15. The one or more non-transitory machine-readable information storage mediums as claimed in claim 13, wherein the plurality of attributes comprises a ripening state and remaining shelf-life of each food item from the plurality of food items.

16. The one or more non-transitory machine-readable information storage mediums as claimed in claim 13, wherein the dynamics of storage is analyzed based on a computed quantity of storage stock, an aggregated remaining shelf-life, a spoilage rate, a purchase rate, one or more variables representing storage-to-storage movements, one or more cost associated factors, and a donation parameter at one or more storage points.

17. The one or more non-transitory machine-readable information storage mediums as claimed in claim 13, wherein the dynamics of transportation is analyzed based on type of vehicles, frequency of the vehicles, temperature control capability and the cost associated with the vehicles used for transportation.

18. The one or more non-transitory machine-readable information storage mediums as claimed in claim 13, wherein the dynamics of retailer is analyzed based a grade distribution, grade flow and demand distribution of the plurality of food items at one or more retailer points.

System **100**

**108**

Memory **102**

Modules **102a**

Repository **102b**

I/O interface(s) **106**

Hardware processor(s) **104**

**FIG. 1**

200

Providing, a virtual representation of a food supply chain network using a stock-and-flow based model, wherein the stock-and-flow based model represents a plurality of dynamics of the food supply chain network — 202

Obtaining, a plurality of data associated with each of a plurality of food items at one or more instances in the virtual representation of the food supply chain network using a food digital twin, wherein the plurality of data is inputted to the stock-and-flow based model — 204

Determining, a status of a plurality of attributes associated with each of the plurality of food items using the plurality of data, wherein the plurality of attributes are indicative of a perishability aspect of each food item from the plurality of food items — 206

Analyzing, the plurality of dynamics of the food supply chain network based on the status of the plurality of attributes associated with each of the plurality of food items using a set of modelling abstractions — 208

Determining in real time, efficacy of each of the set of modelling abstractions for analyzing the plurality of dynamics of the food supply chain network by simulating the stock-and-flow based model using a simulator — 210

Evaluating, sustainability of the food supply chain network based on the efficacy of each of the set of modelling abstractions — 212

**FIG. 2**

**FIG. 3**

**FIG. 4**

**FIG. 5**

$\beta_S$ : Average remaining shelf-life

$\alpha_S$ : degradation rate

$c_S$ : Preservation cost /unit

$if_1 (\beta_{IF1,} <p_{SX}>)$

Storage (St)

$<of_1, \beta_S>$

$<of_M, \beta_S>$

$if_N (\beta_{IFN})$

s: Spoilage rate

d: Donation rate

FIG. 6A

vs: vehicle size

vf: vehicle frequency

Source Storage

$<f_{S2S},$ $\beta_S>$

$<f_{S2S},$ $\beta_T>$

Target Storage

$\delta_T$: transportation delay

$\alpha_V$: degradation rate at vehicle

$c_T$: transportation cost/vehicle

FIG. 6B

<Flow= $f_{DC2R}$, Average shelf-life at the entry point of retailer R = $\beta_R$>

$f_{DC2R} = f_{GA} + f_{GB} + F_{GC}$ **Retailers**

$f_{GA}$

$f_{GB}$

$f_{GC}$

Grade A ($\beta_{AM}$, @ $p_A$)

$f_{A2B}$

Grade B ($\beta_{BM}$, @ $p_B$)

$f_{B2C}$

Grade C ($\beta_{CM}$, @ $p_C$)

$f_{C2W}$

Wastage

$d_A$

$d_B$

$d_C$

Demand for Grade A ($cd_A$)

Demand for Grade B ($cd_B$)

Demand for Grade C ($cd_C$)

Cumulative Consumption Demand in a region (D)

**Consumers**

(c) Quality, price and demand related dynamics at retailer end

**FIG. 6C**

**FIG. 7A**

**FIG. 7B**

**FIG. 7C**

**FIG. 7D**

FIG. 8A

FIG. 8B

**Demand Fulfilment (%)**

FIG. 8C

**Grade-wise Inflow (absolute)**

FIG. 8D

Europäisches Patentamt

European Patent Office

Office européen des brevets

## EUROPEAN SEARCH REPORT

**Application Number**

EP 24 21 0188

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KABADURMUS OZGUR ET AL: "A data-driven decision support system with smart packaging in grocery store supply chains during outbreaks", SOCIO-ECONOMIC PLANNING SCIENCES, PERGAMON, AMSTERDAM, NL, vol. 85, 19 August 2022 (2022-08-19), XP087256520, ISSN: 0038-0121, DOI: 10.1016/J.SEPS.2022.101417 [retrieved on 2022-08-19] | 1-3,6-9, 12-15,18 | INV. G06Q10/0631 A23B7/00 A23L19/00 G06F30/20 G06Q10/08 G06Q10/083 G06Q10/087 G06Q30/0201 G06Q30/0202 |
| Y | * the whole document * | 4,5,10, 11,16,17 | |
| Y | MALLIDIS IOANNIS ET AL: "Optimal inventory control policies for avoiding food waste", OPERATIONAL RESEARCH, SPRINGER BERLIN HEIDELBERG, BERLIN/HEIDELBERG, vol. 22, no. 1, 17 February 2020 (2020-02-17), pages 685-701, XP037702107, ISSN: 1109-2858, DOI: 10.1007/S12351-020-00554-W [retrieved on 2020-02-17] | 4,10,16 | **TECHNICAL FIELDS SEARCHED (IPC)** G06Q G06F A23B A23L |
| A | * the whole document * | 1-3,5-9, 11-15, 17,18 | |

-/--

The present search report has been drawn up for all claims

| Place of search | Date of completion of the search | Examiner |
|---|---|---|
| The Hague | 14 January 2025 | Mas Tur, Elena |

EPO FORM 1503 03.82 (P04C01)

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | REN QING-SHAN ET AL: "Ensuring the quality of meat in cold chain logistics: A comprehensive review", TRENDS IN FOOD SCIENCE & TECHNOLOGY, ELSEVIER SCIENCE PUBLISHERS, GB, vol. 119, 7 December 2021 (2021-12-07), pages 133-151, XP086924203, ISSN: 0924-2244, DOI: 10.1016/J.TIFS.2021.12.006 [retrieved on 2021-12-07] | 5,11,17 | |
| A | * the whole document * | 1-4, 6-10, 12-16,18 | |

- - - - -

|  | TECHNICAL FIELDS SEARCHED (IPC) |
|---|---|

The present search report has been drawn up for all claims

| Place of search | Date of completion of the search | Examiner |
|---|---|---|
| The Hague | 14 January 2025 | Mas Tur, Elena |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202321082913